# EUROPEAN PATENT APPLICATION

(11) **EP 1 843 223 A1**
(43) Date of publication of application: **10.10.2007**
(21) Application number: 05704179.0
(22) Date of filing: 27.01.2005
(51) Int. Cl.: G03H 1/04, G11B 7/0065, G11B 7/135, G11C 13/04

(54) **HOLOGRAM RECORDING DEVICE**

(71) Applicant: FUJITSU LIMITED, Kawasaki-shi, Kanagawa 211-8588 (JP)
(72) Inventor: YOSHIKAWA, Hiroyasu c/o FUJITSU LIMITED, Kanagawa 2118588 (JP); TEZUKA, Kouichi c/o FUJITSU LIMITED, Kawasaki-shi Kanagawa 2118588 (JP); UNO, Kazushi c/o FUJITSU LIMITED, Kawasaki-shi Kanagawa 2118588 (JP)
(74) Representative: Seeger, Wolfgang
(86) International application number: PCT/JP2005/001073
(87) International publication number: WO 2006/080061

(57) **Abstract**

A hologram recorder A1 includes a light source (1) of a coherent light beam and a spatial light modulator (5A) for modulating a part of the light beam from the light source (1) into a recording beam which carries two-dimensional information. Another part of the light beam is used as a reference beam to interfere with the recording beam. The recording beam and the reference beam are directed to a hologram recording medium (B). A semi-translucent optical device (4) is disposed between the light source (1) and the spatial light modulator (5A) for letting a part of the beam travel to the spatial light modulator (5A) as a transmitted beam while letting another part of the beam travel to the hologram recording medium (B) as a reflected beam. The recording beam and the reference beam, after being separated from each other by the optical device (4) as the transmitted beam and the reflected beam, travel along the same optical path (L) to irradiate the hologram recording medium (B).

## Description

### TECHNICAL FIELD

The present invention relates to hologram recording devices for recording holograms in hologram recording mediums, using e.g. a laser beam.

### BACKGROUND ART

Fig. 9 shows a conventional hologram recorder (see Patent Document 1 listed below). The illustrated hologram recorder includes a laser beam source 100, a collimator lens 200, a first and a second beam splitters 300A, 300B, a reflector plate 310, a spatial light modulator 400, a two-dimensional detector 500, a recording/reproducing object lens 600, a prism 700, and a reference beam object lens 710. The spatial light modulator 400 is provided by a liquid crystal device configured to allow selective passage of light. The object lenses 600, 710 and the prism 700 are incorporated in a head unit 800. The distance and angle of the head unit 800 with respect to a hologram recording medium B is controlled by a driver 810.

When recording, a light beam from the laser beam source 100 passes through the collimator lens 200, and enters the first beam splitter 300A. The first beam splitter 300A splits the incoming beam into a transmitted beam and a reflected beam. The transmitted beam goes straightly to the spatial light modulator 400 and is modulated by the spatial light modulator 400 into a recording beam which contains two-dimensional information. The recording beam passes through the second beam splitter 300B and the object lens 600 and then hits the hologram recording medium B. The reflected beam serves as a reference beam which makes interference with the recording beam. The reference beam, routed by the reflector plate 310, the prism 700 and the object lens 710, passes through an optical path L2 which is different from an optical path L1 for the recording beam, and comes to the hologram recording medium B. The recording beam and the reference beam interfere with each other in a recording layer 92 of the hologram recording medium B, thereby recording a hologram. When reproducing, the spatial light modulator 400 is not driven, and only the reference beam is applied to the hologram recording medium B. The hologram recording medium B gives out a reproducing beam as the reference beam hits the hologram in the recording layer 92. The reproducing beam passes through the object lens 600 and the second beam splitter 300B, and then received by the two-dimensional detector 500. Thus, information recorded as the hologram in the hologram recording medium B is reproduced.
Patent Document 1: JP-A-H9-305978

However, the conventional hologram recorder as described has a problem of complex optical system because the recording beam optical path L1 and the reference beam optical path L2 are spatially separated from each other. For example, since the recording beam and the reference beam cross with each other at a predetermined, relatively large angle to make the interference, highly accurate positioning is required when assembling the object lenses 600, 710 into the head unit 800.

### DISCLOSURE OF THE INVENTION

The present invention has been proposed under the above-described circumstances. It is therefore an object of the present invention to provide a hologram recorder with a simplified optical system.

In order to solve the above problems, the present invention employs the following technical measures.

A hologram recorder provided by the present invention includes a light source of a coherent light beam and a spatial light modulator for modulating a part of the light beam from the light source into a recording beam which carries two-dimensional information. The recorder uses another part of the light beam as a reference beam to interfere with the recording beam, and directs the recording beam and the reference beam to a hologram recording medium. A semi-translucent optical device is disposed between the light source and the spatial light modulator, allowing a part of the light beam to travel to the spatial light modulator as a transmitted beam while allowing another part of the light beam to travel to the hologram recording medium as a reflected beam. Further, the recording beam and the reference beam, after being separated from each other by the optical device as the transmitted beam and the reflected beam, travel along the same optical path to irradiate the hologram recording medium.

Preferably, the recording beam after passing through the optical device and being modulated by the spatial light modulator passes again through the optical device in a reverse direction and travel along the optical path, while the reference beam, after being reflected on the optical device, travels with the recording beam along the optical path to irradiate the hologram recording medium.

Preferably, a beam splitter is disposed between the light source and the optical device, for letting the light beam travel to the optical device as a transmitted beam, and letting the recording beam and the reference beam coming back from the optical device travel to the hologram recording medium as reflected beams.

Preferably, the hologram recorder of the present invention may further comprise a two-dimensional detector for reading out hologram information recorded in the hologram recording medium. The spatial light modulator is not driven for reproduction so that only the reference beam is applied to the hologram recording medium. The two-dimensional detector is configured to receive a light beam from the hologram recording medium through the beam splitter during the reproduction.

Preferably, the optical device may comprise a half mirror including an incidence surface formed with a dielectric film, while the spatial light modulator may comprise a deformable mirror device.

Preferably, the optical device has a curved beam-emitting surface facing the spatial light modulator.

Preferably, the hologram recorder of the present invention may further comprise a phase plate disposed between the optical device and the spatial light modulator.

Preferably, the optical device may comprise a half mirror including an incidence surface formed with a dielectric film, and the spatial light modulator may comprise a liquid crystal device.

Preferably, the hologram recorder of the present invention may further comprise a reflector plate disposed on a side of the spatial light modulator away from the optical device, where the reflector plate reflects a light beam passing through the spatial light modulator so that the reflected light beam passes again through the modulator in a reverse direction.

Preferably, the hologram recorder of the present invention may further comprise a phase plate disposed between the spatial light modulator and the reflector plate or between the optical device and the spatial light modulator.

### BRIEF DESCRIPTION OF THE DRAWINGS

Fig. 1 is a diagram showing the configuration of a hologram recorder according to a first embodiment of the present invention.
Fig. 2 illustrates the reproducing state of the hologram recorder in Fig. 1.
Fig. 3 is a sectional view showing a primary portion of the hologram recorder in Fig. 1.
Fig. 4 is a sectional view showing a primary portion of a hologram recorder according to a second embodiment of the present invention.
Fig. 5 is a sectional view showing a primary portion of a hologram recorder according to a third embodiment of the present invention.
Fig. 6 is a diagram showing the configuration of a hologram recorder according to a fourth embodiment of the present invention.
Fig. 7 is a sectional view showing a primary portion of the hologram recorder in Fig. 6.
Fig. 8 is a sectional view showing a primary portion of a hologram recorder according to a fifth embodiment of the present invention.

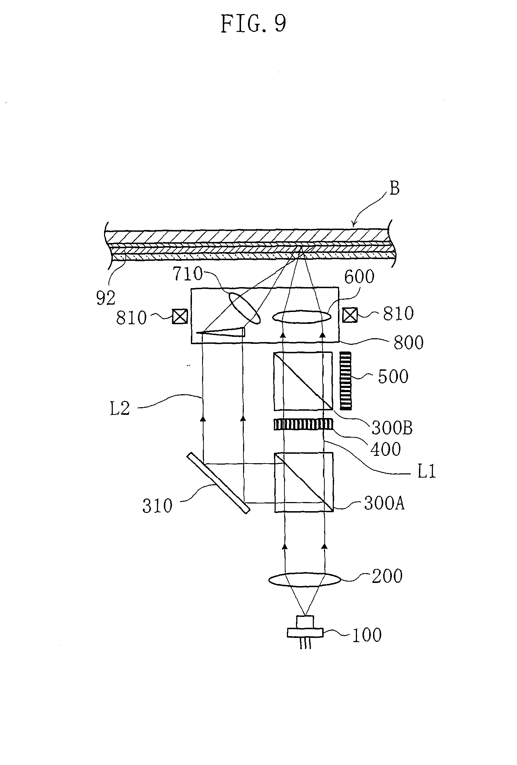

Fig. 9 is a diagram showing the configuration of a conventional hologram recorder.

### BEST MODE FOR CARRYING OUT THE INVENTION

Preferred embodiments of the present invention will be described below with reference to the accompanying drawings.

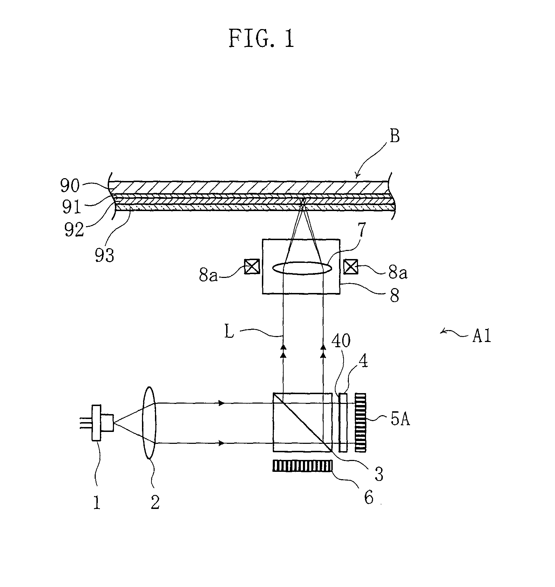

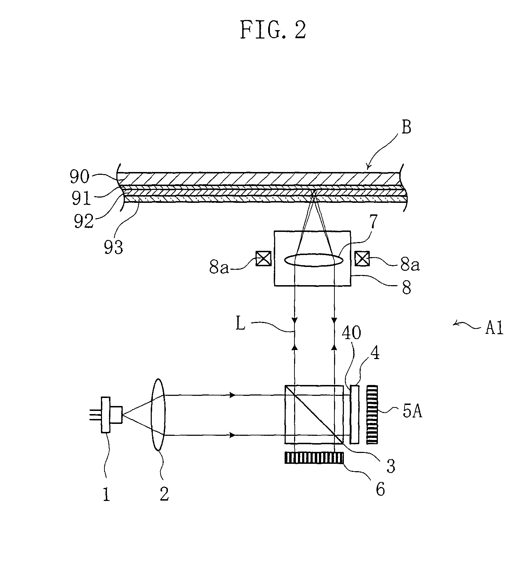

Figs. 1 through 3 show a first embodiment of a hologram recorder according to the present invention. Fig. 1 illustrates a recording state, whereas Fig. 2 illustrates a reproducing state.

As shown in Fig. 1 and Fig. 2, a hologram recorder A1 includes a light source 1, a collimator lens 2, a beam splitter 3, a semi-translucent optical device 4, a spatial light modulator 5A, a two-dimensional detector 6, and an object lens 7. The object lens 7 is incorporated in a head unit 8. The distance and angle of the head unit 8 is with respect to the hologram recording medium B is controlled by a driver 8a. The hologram recording medium B is formed by laminating a reflection film 91, a recording layer 92, and a protection film 93, on a substrate 90. Holograms are recorded in the recording layer 92 of the hologram recording medium B by interference between a recording beam and a reference beam.

The light source 1 is provided by a semiconductor laser device for example. When recording, as well as when reproducing, the light source 1 gives out a coherent laser beam of a relatively narrow band.

The collimator lens 2 changes the laser beam which comes from the light source 1 into a parallel beam. The parallel laser beam enters the beam splitter 3.

The beam splitter 3 is between the light source 1 and the optical device 4. The beam splitter 3 allows the incoming beam from the light source 1 to pass straightly to the optical device 4 as a transmitted beam while reflecting generally all of the beams coming back from the optical device 4, at an angle of 90 degrees. The reflected light travels to the object lens 7.

The optical device 4 is provided by a half mirror, and has an incidence surface 40 formed with a dielectric film. The optical device 4 is disposed between the beam splitter 3 and the spatial light modulator 5A, with the incidence surface 40 facing toward the beam splitter 3. A part of the incoming beam passes through the optical device 4, and travels straightly to the spatial light modulator 5A whereas another part of the incoming beam reflects on the incidence surface 40 and goes back to the beam splitter 3. The transmitted beam and the reflected beam thus separated from each other by the optical device 4 will serve as the recording beam and the reference beam.

The spatial light modulator 5 is provided by a DMD (Deformable Mirror Device), and driven only at the time of recording. The spatial light modulator 5 selectively reflects, and thereby modulates the transmitted beam from the optical device 4 into the recording beam which contains two-dimensional information. The recording beam 5 which comes out of the spatial light modulator 5 passes through the optical device 4 again, in the opposite direction, and returns to the beam splitter 3.

The two-dimensional detector 6 is provided by e.g. a CCD area sensor or a CMOS area sensor, and is driven mainly when at the time of reproduction. The two-dimensional detector 6 converts the received reproducing beam into digital signals, thereby reading out two-dimensional information which is recorded as a hologram in the hologram recording medium B.

The object lens 7 is disposed between the beam splitter 3 and the hologram recording medium B. When recording, the recording beam and the reference beam travel as shown in Fig. 1, from the beam splitter 3 along the same optical path L, and then to the object lens 7. The recording beam and the reference beam are then directed by the object lens 7 so they will interfere with each other in the recording layer 92 of the hologram recording medium B. Through this process a hologram is recorded in the recording layer 92. When reproducing, as shown in Fig. 2, only the reference beam is used, which travels along the optical path L and enters the object lens 7, whereby the reference beam is directed to the hologram recording medium B. As the hologram in the recording layer 92 is hit by the reference beam, the hologram recording medium B gives out a reproducing beam. The reproducing beam travels in the opposite direction as did the reference beam, through the object lens 7 to the beam splitter 3, and after passing straightly through this beam splitter 3, the beam is received by the two-dimensional detector 6. Through this process, information recorded as a hologram is read out.

Next, the function of the hologram recorder A1 will be described.

At the time of recording as shown in Fig. 1, a laser beam from the light source 1 passes through the collimator lens 2, passes the beam splitter 3 straightly, and enters the optical device 4. In the optical device 4, a part of the incoming beam passes through the incidence surface 40, thereby becomes a transmitted beam, and enters the spatial light modulator 5A. Another part of the incoming beam reflects on the incidence surface 40, and enters the beam splitter 3 as a reference beam.

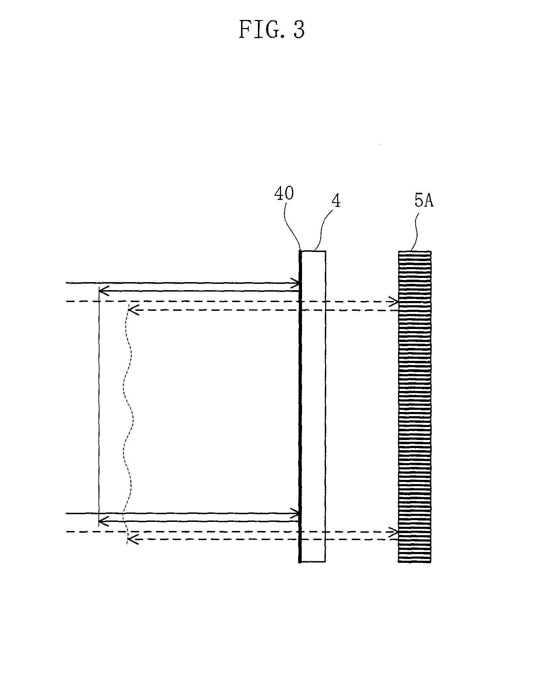

As shown in broken lines in Fig. 3, the beam which enters the spatial light modulator 5A is reflected or absorbed by corresponding pixels, thereby modulated. The beam modulated by the spatial light modulator 5A becomes a recording beam which contains two-dimensional information. The recording beam passes through the optical device 4 again but in the opposite direction, and enters the beam splitter 3.

The recording beam passes through the optical device 4, comes to the beam splitter 3, refracts substantially at the right angle in the beam splitter 3, then passes through the object lens 7 and irradiates the hologram recording medium B. The reference beam also reflects on the optical device 4, travels to the beam splitter 3, refracts substantially at the right angle in the beam splitter 3, then passes through the object lens 7 and irradiates the hologram recording medium B. In other words, the recording beam and the reference beam travel along the same optical path L and then they are applied to the hologram recording medium B.

As shown in Fig. 3, the reference beam makes a simple reflection, and therefore has a wave surface of a consistent phase. On the other hand, the recording beam which is modulated by the spatial light modulator 5A has a wave surface of an inconsistent phase. Thus, although the recording beam and the reference beam are applied to the hologram recording medium B via the identical optical path L, they interfere with each other efficiently in the recording layer 92. Through this process, a hologram which contains two-dimensional information is recorded in the recording layer 92.

At the time of reproducing as illustrated in Fig. 2, a beam from the light source 1 passes through the collimator lens 2 and the beam splitter 3, enters the optical device 4, and is split by the optical device 4 into a transmitted beam and a reflected beam. At the time of reproduction, however, the spatial light modulator 5A is not driven and all of the incoming beams are absorbed; as a result, the beam reflected by the optical device 4, i.e. only the reference beam, travels along the optical path L to irradiate the hologram recording medium B.

As the hologram in the recording layer 92 is hit by the reference beam, the hologram recording medium B gives out a reproducing beam. The reproducing beam travels in the opposite direction as did the reference beam, through the object lens 7, then through the beam splitter 3 straightly, and is received by the two-dimensional detector 6. Through this process, information recorded as the hologram in the recording layer 92 of the hologram recording medium B is reproduced.

Therefore, according to the hologram recorder A1 offered by the present embodiment, it is possible to simplify the optical system from the light source 1 to the object lens 7 since the recording beam and the reference beam travel along the same optical path L. For example, the object lens 7 which is an element that constitutes the optical system serves both for the recording beam and the reference beam, and the object lens 7 can be assembled to the head unit 8 easily.

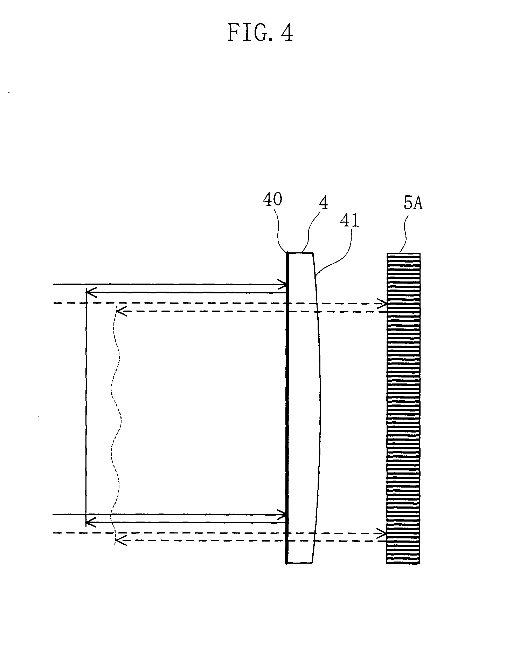

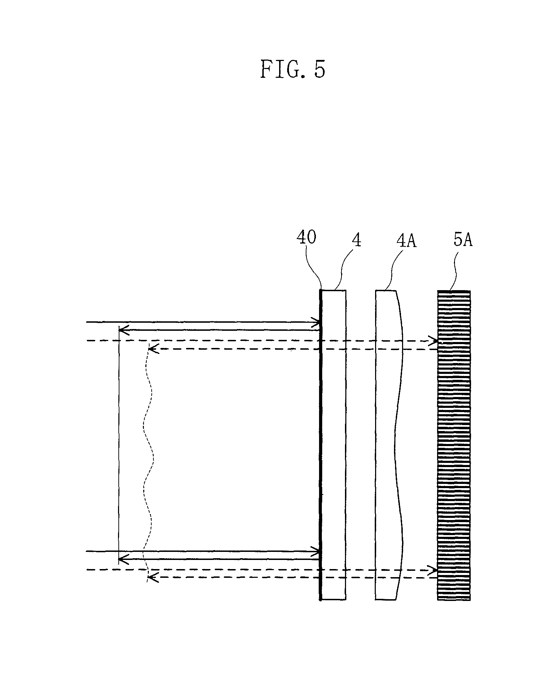

Figs. 4 through 8 show other embodiments of the hologram recorder according to the present invention. In these figures, elements which are the same or similar to those used in the first embodiments are indicated with the same alphanumeric codes. Those which are not shown in these figures are exactly the same as in the first embodiment, and thus will be referred to with the same codes and their description will not be repeated hereafter.

Fig. 4 is a sectional view showing a primary portion of a hologram recorder according to a second embodiment of the present invention. In the second embodiment, the optical device 4 has a beam-emitting surface 41 formed as a convex surface. As shown in broken lines in Fig. 4, the recording beam, which passes the convex emitting surface 41 in both directions, becomes optically more desirable for making interference with the reference beam. Such a recording beam as this also travels along the same optical path L as the reference beam, and then hits the hologram recording medium B. The hologram recorder according to the second embodiment provides a recording beam wave surface and a reference beam wave surface which are more appropriate for making interference, enabling to record holograms more efficiently. It should be noted here that the same advantage is offered by an optical device which has a concave beam-emitting surface.

Fig. 4 is a sectional view showing a primary portion of a hologram recorder according to a third embodiment. In the third embodiment, a phase plate 4A is disposed between the optical device 4 and the spatial light modulator 5A. The phase plate 4A gives a predetermined phase difference to the recording beam, thereby making the phase of the recording beam wave surface more inconsistent. Such a recording beam as this also travels along the same optical path L as the reference beam, and then hits the hologram recording medium B. The hologram recorder according to the third embodiment as this also provides a recording beam wave surface and a reference beam wave surface which are more appropriate for making interference, enabling to record holograms more efficiently.

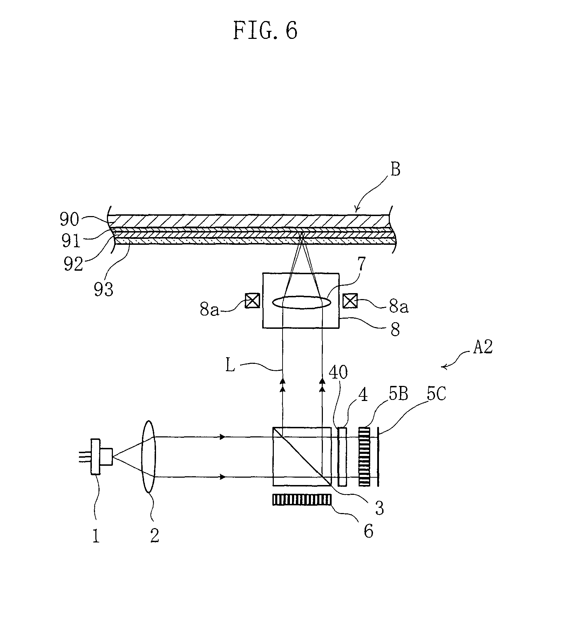

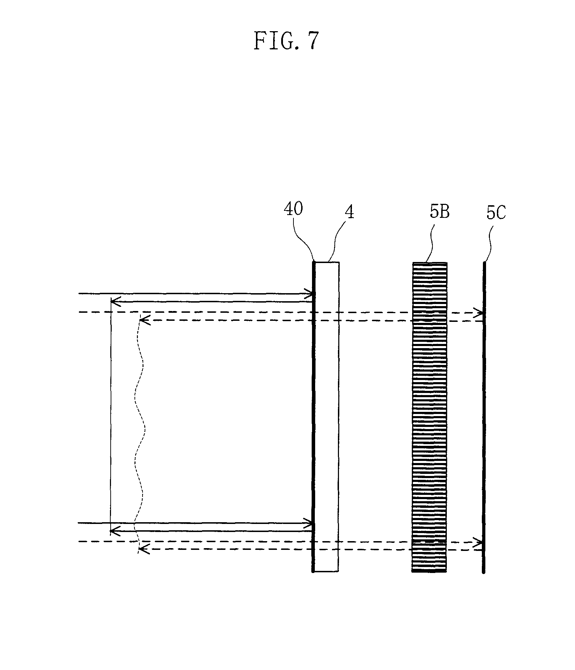

Fig. 6 and Fig. 7 show a hologram recorder A2 according to a fourth embodiment. The fourth embodiment includes a spatial light modulator 5B provided by a liquid crystal device. On the side of the spatial light modulator 5B facing away from the optical device 4, is disposed a reflector place 5C. As shown in broken lines in Fig. 7, the spatial light modulator 5B modulates the transmitted beam into a recording beam which has two-dimensional information, by selectively passing the transmitted beam. The recording beam which has passed through the spatial light modulator 5B travels to the reflector plate 5C, reflects on the reflector plate 5C, and thus passes through the spatial light modulator 5B again, then passes through the optical device 4, and returns to the beam splitter 3. Such a hologram recorder A2 according to the fourth embodiment also enables to simplify the optical system from the light source 1 to the object lens 7 since the recording beam and the reference beam travel along the same optical path L.

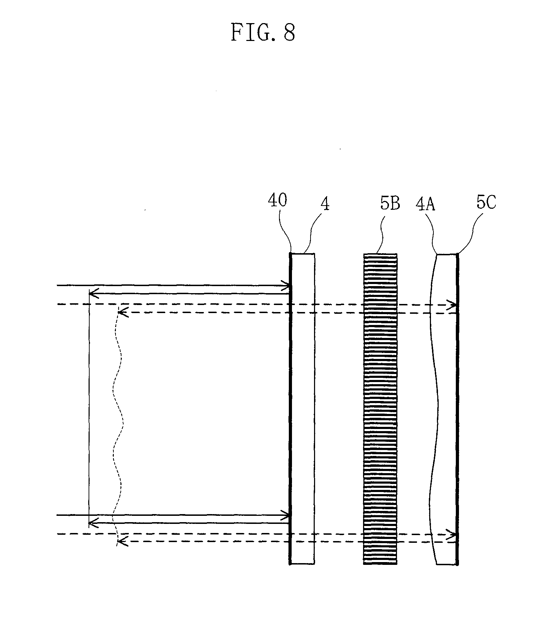

Fig. 8 shows a hologram recorder according to a fifth embodiment. In the fifth embodiment, the recorder includes the same elements as in the fourth embodiment, and in addition, a phase plate 4A is disposed between the spatial light modulator 5B and the reflector plate 5C. As shown in broken lines in Fig. 8, the recording beam which travels from the spatial light modulator 5B to the reflector plate 5C is given a predetermined phase difference by the phase plate 4A. Therefore, the hologram recorder according to the fifth embodiment also makes the recording beam wave surface the reference beam wave surface more appropriate for making interference, enabling to record holograms more efficiently. It should be noted here that the same advantage is offered by a phase plate disposed between the optical device and the spatial light modulator.

## Claims

1. A hologram recorder comprising: a light source of a coherent light beam; and a spatial light modulator for modulating a part of the light beam from the light source into a recording beam which carries two-dimensional information; another part of the light beam being used as a reference beam to interfere with the recording beam, the recording beam and the reference beam being directed to a hologram recording medium,
wherein a semi-translucent optical device is disposed between the light source and the spatial light modulator, the optical device allowing a part of the light beam to travel to the spatial light modulator as a transmitted beam, while also allowing another part of the light beam to travel to the hologram recording medium as a reflected beam,
wherein the recording beam and the reference beam are, after separated as the transmitted beam and the reflected beam by the optical device, caused to travel along a same optical path to irradiate the hologram recording medium.

2. The hologram recorder according to claim 1, wherein the recording beam, after passing through the optical device and being modulated by the spatial light modulator, passes again through the optical device in a reverse direction and travels along the optical path, and wherein the reference beam, after being reflected on the optical device, travels with the recording beam along the optical path to irradiate the hologram recording medium.

3. The hologram recorder according to claim 2, further comprising a beam splitter disposed between the light source and the optical device, the beam splitter being configured to allow the light beam to travel to the optical device as a transmitted beam, and also configured to direct the recording beam and the reference beam coming back from the optical device travel as reflected beams to the hologram recording medium.

4. The hologram recorder according to claim 3, further comprising a two-dimensional detector for reading out hologram information recorded in the hologram recording medium, wherein the spatial light modulator is undriven for reproduction so that only the reference beam is applied to the hologram recording medium, the two-dimensional detector being configured to receive a light beam from the hologram recording medium through the beam splitter during the reproduction.

5. The hologram recorder according to any one of claims 1-4,
wherein the optical device comprises a half mirror including an incidence surface formed with a dielectric film, the spatial light modulator comprising a deformable mirror device.

6. The hologram recorder according to claim 5, wherein the optical device includes a curved beam-emitting surface facing the spatial light modulator.

7. The hologram recorder according to claim 5, further comprising a phase plate disposed between the optical device and the spatial light modulator.

8. The hologram recorder according to any one of claims 1-4,
wherein the optical device comprises a half mirror including an incidence surface formed with a dielectric film, the spatial light modulator comprising a liquid crystal device.

9. The hologram recorder according to claim 8, further comprising a reflector plate disposed on a side of the spatial light modulator away from the optical device, wherein the reflector plate reflects a light beam passing through the spatial light modulator so that the reflected light beam passes again through the modulator in a reverse direction.

10. The hologram recorder according to claim 9, further comprising a phase plate disposed between the spatial light modulator and the reflector plate or between the optical device and the spatial light modulator.
